Europäisches Patentamt

European Patent Office

Office européen des brevets

(11) Veröffentlichungsnummer: **0 474 903 A1**

## (12) EUROPÄISCHE PATENTANMELDUNG

(21) Anmeldenummer: **90117582.8**

(22) Anmeldetag: **12.09.90**

(51) Int. Cl.5: **H01L 31/16**, H01L 31/173

(43) Veröffentlichungstag der Anmeldung:
**18.03.92 Patentblatt 92/12**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Bayat, Hazim**
**Adlerstrasse 26 a**
**W-2084 Rellingen(DE)**

(54) **Optoelektronisches Koppelelement.**

(57) Eine Optokoppler-Vorrichtung mit mindestens zwei Lichtsendern bzw. mit mindestens zwei Lichtempfängern soll eine Verminderung von Anschluß-Pin's ermöglichen. Für mindestens zwei Lichtsender bzw. für mindestens zwei Lichtempfänger, die für verschiedene Signalkanäle vorgesehen sind, ist ein gemeinsamer elektrischer Anschluß vorhanden.

FIG 7

EP 0 474 903 A1

Die Erfindung betrifft eine Optokoppler-Vorrichtung mit mindestens zwei Lichtsendern und/oder mit mindestens zwei Lichtempfängern.

Optokoppler dienen zur Signalübertragung zwischen Stromkreisen bei gleichzeitiger galvanischer Trennung. Die Signalübertragung erfolgt optisch mit einer Strahlung im sichtbaren Bereich bzw. im Infrarot-Bereich. Als Lichtsender dienen bevorzugt Verbindungs-Halbleiter. Der Eingangsstrom (Flußstrom) des Lichtsenders liegt üblicherweise im mA-Bereich. Zur Umwandlung der Strahlung zurück in ein elektrisches Signal wird bevorzugt ein Silizium-Detektor (Fotodiode, Fototransistor, integrierter Schaltkreis mit integrierter Fotodiode) verwendet. Je nach Typ des verwendeten Optokopplers sind Übertragungsfrequenzen von Gleichstrom bis in den MHz-Bereich hinein verwendbar.

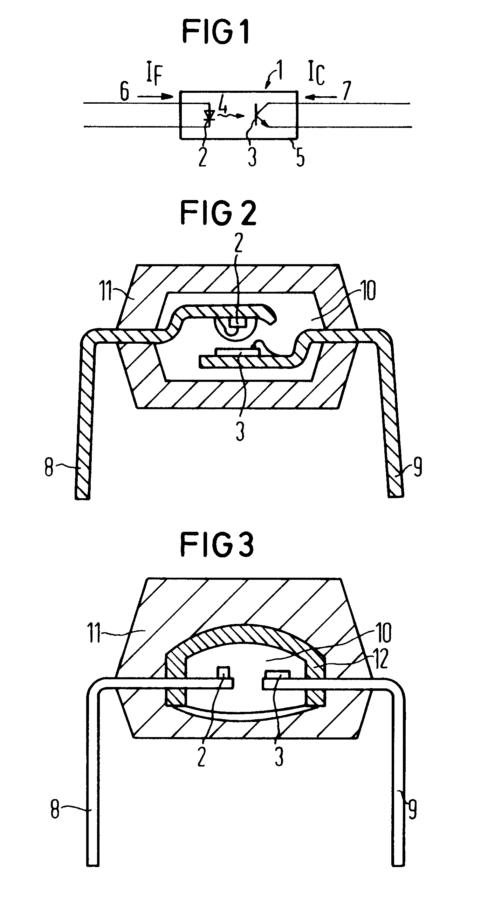

FIG 1 zeigt das Funktionsbild eines Optokopplers 1. Als Lichtsender 2 dient dabei bevorzugt eine lichtemittierende Diode (LED). Als Lichtempfänger 3 dient bevorzugt ein Fototransistor. Lichtsender 2 und Lichtempfänger 3 sind in einem gemeinsamen Gehäuse 5 untergebracht. Fließt durch den Lichtsender 2 ein Eingangsstrom 6, so gibt der Lichtsender 2 eine Strahlung 4 ab, die vom Lichtempfänger 3 detektiert wird. Durch den Lichtempfänger 3 fließt der Ausgangsstrom 7. Für die Stromübertragung genügt ausgangsseitig der elektrische Anschluß an Emitter und Kollektor des im Beispiel verwendeten Transistors.

Optokoppler sind üblicherweise in Dual-In-Line-Plastic (DIP)-Gehäusen mit vier bis sechzehn Anschlüssen erhältlich. Lichtsender und Lichtempfänger sind üblicherweise über einen lichtleitenden, elektrisch isolierenden Kunststoff miteinander gekoppelt. Damit die Funktion des Optokopplers nicht durch äußere Einflüsse (Licht, Staub bzw. Umwelteinflüsse) gestört wird, ist das ganze System des Optokopplers von einer lichtdichten, elektrisch isolierenden Masse, üblicherweise einer Preßmasse, umhüllt.

FIG 2 und 3 zeigen zwei verschiedene Aufbau-Varianten bei Optokopplern. Bei FIG 2 liegen sich Lichtsender 2 und Lichtempfänger 3 gegenüber (face to face). Bei FIG 3 liegen Lichtsender 2 und Lichtempfänger 3 nebeneinander (koplanare Anordnung). FIG 2 zeigt die heute gebräuchlichste Aufbauvariante eines Optokopplers. Die inneren Abstände zwischen elektrisch leitenden Teilen betragen dabei heute etwa ein zehntel Millimeter oder mehr. Der Lichtsender 2 ist in den FIG 2 und 3 auf einem Senderleiterband 8 angeordnet. Lichtempfänger 3 ist auf einem Empfängerleiterband 9 befestigt. Der Optokoppler besitzt einen Lichtleiter 10, der üblicherweise aus Kunstharz oder Silicen besteht. Der Lichtleiter 10 ist üblicherweise von einer lichtundurchlässigen Umhüllung 11 umgeben. Bei einem Optokoppler nach FIG 3 ist zwischen Lichtleiter 10 und lichtundurchlässiger Umhüllung 11 noch eine Reflexionsschicht 12 vorgesehen. Bei einem Optokoppler nach FIG 3 ergeben sich größere definierte innere Abstände zwischen elektrisch leitenden Teilen innerhalb des Optokopplers und somit sehr gute Isolationseigenschaften.

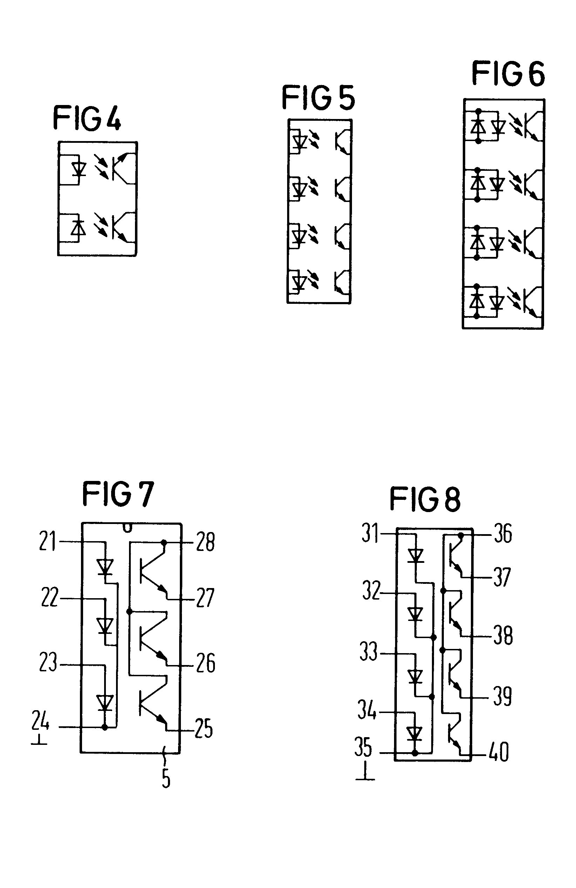

Es gibt Optokoppler, bei denen zwei oder mehr isolierte Signalkanäle in einem einzigen Gehäuse enthalten sind. Solche Mehrfach-Optokoppler ermöglichen geringen Platzbedarf, was besonders günstig ist in Hinblick auf eine Befestigung des Mehrfach-Optokopplers auf einer Platine. Solche Mehrfach-Optokoppler ermöglichen darüber hinaus die Verwendung von weniger Teilen und eine bessere Anpassung des Kanal-zu-Kanal-Stromübertragungsverhältnisses. FIG 4 zeigt einen Zweifach-Optokoppler mit zwei isolierten Signal-Kanälen zwischen jeweils einem Lichtsender und einem Lichtempfänger in einem einzigen Gehäuse. FIG 5 zeigt einen Vierfach-Optokoppler mit vier Signalkanälen zwischen jeweils einem Lichtsender und einem Lichtempfänger in einem einzigen Gehäuse. Als Lichtempfänger sind dabei Transistoren verwendet. Die Basis dieser Transistoren ist nicht beschaltet. Dadurch ergibt sich eine hohe Gleichtaktstörfestigkeit (Common mode transient immunity). Solche Mehrfach-Optokoppler finden Anwendung zum Erkennen von Gleich- bzw. Wechselstromsignalen bzw. in Datenein-/-ausgabe und Steuersystemen unterschiedlicher Arbeitsgeschwindigkeit. FIG 6 zeigt einen Vierfach-Optokoppler mit Wechselstromeingang, wie er zum Erkennen von Wechselspannung verwendet werden kann. Pro Signal-Kanal sind dabei zwei antiparallel geschaltete Infrarot-Lumineszenzdioden als Lichtsender und ein NPN-Silizium-Fototransistor als Empfänger verwendet.

Beim Stand der Technik sind selbst bei Anordnung mehrerer Lichtsender bzw. Lichtempfänger in einem einzigen Gehäuse für jedes zu trennende Signal in einer Optokoppler-Vorrichtung mindestens vier elektrisch Anschlüsse notwendig.

Soll mit einem Computer eine Steuer- und Regelungsaufgabe mit Hilfe einer Optokoppler-Vorrichtung gelöst werden, sind häufig mehrere, beispielsweise zwanzig Optokoppler erforderlich. Für diese Optokoppler wird viel Platz auf einer Platine benötigt. Überdies ist eine solche Platine mit mehreren Optokopplern nicht sehr leicht zu entwickeln. Beim Stand der Technik können pro Leiterplatte nur wenige Optokoppler eingesetzt werden, bzw. müssen beim Stand der Technik sehr große Platinen verwendet werden.

Der vorliegenden Erfindung liegt die Aufgabe zugrunde, eine Optokoppler-Vorrichtung der eingangs genannten Art anzugeben, die eine Verminderung von Anschluß-Pin's insbesondere bei der Verwendung von Optokopplern auf einer Leiterplatte ermöglicht.

Diese Aufgabe wird erfindungsgemäß durch eine Optokoppler-Vorrichtung nach Anspruch 1 bzw. Anspruch 6 gelöst.

Die Erfindung ermöglicht eine Optokoppler-Vorrichtung, bei der im Durchschnitt pro Signal-Kanal weniger als vier Anschluß-Pin's erforderlich sind.

Die Erfindung findet Anwendung bei Optokoppler-Vorrichtungen, bei denen mindestens zwei Signal-Kanäle vorhanden sind.

Vorteilhafterweise dient ein einziger gemeinsamer elektrischer Anschluß für sämtliche in einem einzigen Gehäuse einer Optokoppler-Vorrichtung enthaltenen Lichtsender.

Vorteilhafterweise dient ein einziger gemeinsamer elektrischer Anschluß für sämtliche in einem einzigen Gehäuse enthaltenen Lichtempfänger einer Optokoppler-Vorrichtung.

Die Erfindung ermöglicht die Verwendung kleinerer Platinen. Die Erfindung ermöglicht die leichtere Entflechtung von Platinen.

Die Erfindung ermöglicht es, daß für den zweiten und jeden weiteren in einer Optokoppler-Vorrichtung enthaltenen Optokoppler zwei Anschluß-Pin's gespart werden. Die Erfindung ermöglicht es, daß für den zweiten und jeden weiteren Signal-Kanal in einer Optokoppler-Vorrichtung gegenüber dem Stand der Technik zwei Anschluß-Pin's eingespart werden. Bei zwei in einer Optokoppler-Vorrichtung enthaltenen Optokopplern spart man also zwei Anschluß-Pin's, bei drei Optokopplern in einer Optokoppler-Vorrichtung spart man vier Anschluß-Pin's, bei vier Optokopplern in einer Optokoppler-Vorrichtung spart man sechs Anschluß-Pin's, bei sechs Optokopplern in einer Optokoppler-Vorrichtung spart man zehn Anschluß-Pin's, usw.

Bevorzugt besitzen die Lichtempfänger einen gemeinsamen Versorgungsanschluß (gemeinsamer Kollektor). Bevorzugt besitzen die Lichtsender einen gemeinsamen Masseanschluß (gemeinsame Katode).

Die Erfindung wird im folgenden anhand der Zeichnung näher erläutert.

FIG 1 zeigt die Grundschaltung eines Optokopplers.

FIG 2 und 3 zeigen verschiedene Aufbau-Varianten eines Optokopplers.

FIG 4 bis 6 zeigen Mehrfach-Optokoppler nach dem Stand der Technik. FIG 7 und 8 zeigen Optokoppler-Vorrichtungen nach der Erfindung.

FIG 7 zeigt eine Optokoppler-Vorrichtung nach der Erfindung, bei der drei Optokoppler in einem einzigen Gehäuse 5 untergebracht sind. Die Optokoppler-Vorrichtung nach FIG 7 besitzt drei Optokoppler und insgesamt acht Anschluß-Pin's. Die Lichtsender der drei Optokoppler besitzen einen einzigen gemeinsamen Masse-Anschluß (gemeinsame Katode) 24. Die Lichtempfänger der drei Optokoppler besitzen einen einzigen gemeinsamen Versorgungsanschluß (gemeinsamer Kollektor) 25. Der gemeinsame Anschluß 25 der Lichtempfänger der drei Optokoppler ist mit der Versorgungsspannung am Ausgang 26, 27, 28 beschaltet. Die drei Lichtsender der drei Optokoppler besitzen jeweils ein Anschluß-Pin 21, 22, 23 für die Ansteuerung dieser Lichtsender. Ausgangsseitig besitzt jeder Emitter der Lichtempfänger der drei Optokoppler einen Anschluß-Pin.

FIG 8 zeigt eine Optokoppler-Vorrichtung mit vier Optokopplern, bei denen die Lichtsender einen gemeinsamen Masseanschluß 35 und jeweils einen eigenen Anschluß-Pin 31-34 zur individuellen Ansteuerung dieser Lichtsender besitzen. Die Lichtempfänger dieser vier Optokoppler in FIG 8 besitzen einen gemeinsamen Versorgungsanschluß 36 und je einen eigenen Anschluß-Pin 37-40 für den jeweiligen individuellen Ausgang des jeweiligen Optokopplers.

**Patentansprüche**

1. Optokoppler-Vorrichtung mit mindestens zwei Lichtsendern,
   **dadurch gekennzeichnet,** daß für mindestens zwei Lichtsender, die für verschiedene Signalkanäle vorgesehen sind, ein gemeinsamer elektrischer Anschluß vorhanden ist.

2. Optokoppler-Vorrichtung nach Anspruch 1,
   **gekennzeichnet durch** einen gemeinsamen Masse-Anschluß für mindestens zwei Lichtsender.

3. Optokoppler-Vorrichtung nach Anspruch 1,
   **gekennzeichnet durch** einen gemeinsamen Versorgungsanschluß für mindestens zwei Lichtsender.

4. Optokoppler-Vorrichtung nach Anspruch 1,
   **gekennzeichnet durch** eine gemeinsame Katode für mindestens zwei Lichtsender.

5. Optokoppler-Vorrichtung nach Anspruch 1,
   **gekennzeichnet durch** eine gemeinsame Anode für mindestens zwei Lichtsender.

6. Optokoppler-Vorrichtung mit mindestens zwei Lichtempfängern,
   **dadurch gekennzeichnet,** daß für mindestens zwei Lichtempfänger, die für verschiedene Signalkanäle vorgesehen sind, ein gemeinsamer elektrischer Anschluß vorhanden ist.

7. Optokoppler-Vorrichtung nach Anspruch 6,
   **gekennzeichnet durch** einen gemeinsamen Kollektor für mindestens zwei Lichtempfänger.

**8.** Optokoppler-Vorrichtung nach Anspruch 6, **gekennzeichnet durch** einen gemeinsamen Emitter für mindestens zwei Lichtempfänger.

**9.** Optokoppler-Vorrichtung nach Anspruch 6, **gekennzeichnet durch** einen gemeinsamen Versorgungsanschluß für mindestens zwei Lichtempfänger.

**10.** Optokoppler-Vorrichtung nach einem der Ansprüche 1 bis 9, **gekennzeichnet durch** ein gemeinsames Gehäuse.

**11.** Verwendung einer Optokoppler-Vorrichtung nach einem der Ansprüche 1 bis 10 für eine Computer-Interface-Schaltung für Signalübertragung auf einer Platine.

FIG 1

FIG 2

FIG 3

FIG 4

FIG 5

FIG 6

FIG 7

21
22
23
24 ⊥

28
27
26
25

5

FIG 8

31
32
33
34
35 ⊥

36
37
38
39
40

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 886 976   (R.J. TOLMIE) <br> * Ganzes Dokument * | 1,6 | H 01 L 31/16 <br> H 01 L 31/173 |
| A |  | 3,5,7,11 | |
| | – – – | | |
| X | PATENT ABSTRACTS OF JAPAN, Band 5, Nr. 27 (E-46)[699], 18. Februar 1981; <br> & JP-A-55 153 379 (MITSUBISHI) 29-11-1980 | 1 | |
| | – – – | | |
| A | IDEM | 2,3,5 | |
| | – – – | | |
| X | PATENT ABSTRACTS OF JAPAN, Band 8, Nr. 261 (E-281)[1698], 30. November 1984; <br> & JP-A-59 132 176 (TOSHIBA K.K.) 30-07-1984 | 1,6 | |
| | – – – | | |
| A | IDEM | 2,3,9 | |
| | – – – | | |
| X | FR-A-1 424 455   (TEXAS INSTRUMENTS) <br> * Figur 3; Ansprüche * | 1 | |
| A |  | 2,3,4 | |
| | – – – | | |
| X | ELECTRONIQUE APPLICATIONS, Nr. 15, 1980, Seiten 5-15, Paris, FR; J.M. MALFERIOL: "Les photocoupleurs" <br> * Figur 12 * | 6 | RECHERCHIERTE SACHGEBIETE (Int. Cl.5) |
| | – – – | | H 01 L 31/00 |
| A | IDEM | 7-10 | |
| | – – – | | |
| A | US-A-2 152 749   (P.M.J. MORRISH) <br> * Ganzes Dokument * | 1,6,11 | |
| | – – – – – | | |

Der vorliegende Recherchenbericht wurde für alle Patentansprüche erstellt

| Recherchenort | Abschlußdatum der Recherche | Prüfer |
|---|---|---|
| Den Haag | 17 Mai 91 | MATHYSSEK K. |